# EUROPEAN PATENT APPLICATION

(11) **EP 1 865 344 A1**
(43) Date of publication of application: **12.12.2007**
(21) Application number: 06712935.3
(22) Date of filing: 02.02.2006
(51) Int. Cl.: G02B 5/08

(54) **HIGH REFLECTION MIRROR AND PROCESS FOR PRODUCING THE SAME**

(30) Priority: 31.03.2005 JP 2005102839; 07.06.2005 JP 2005167066
(71) Applicant: Asahi Glass Company, Limited, Tokyo 100-8405 (JP)
(72) Inventor: SHIN, Naoko, Ichihara-shi, Chiba 2908566 (JP); MORIMOTO, Tamotsu,Asahi Glass Company, Limited, Yokohama-shi, Kanagawa 221-8755 (JP); MIYAZAWA, Hideaki, Ichihara-shi, Chiba 2908566 (JP); KAWASAKI, Masato, Ichihara-shi, Chiba 2908566 (JP)
(74) Representative: Müller-Boré & Partner Patentanwälte
(86) International application number: PCT/JP2006/301792
(87) International publication number: WO 2006/112107

(57) **Abstract**

To provide a high reflection mirror which exhibits a high reflectance in a visible light region and which has moisture resistance, in particular, being capable of retaining the high reflectance and high resistance to hydrogen sulfide even after being exposed to high temperature and high humidity conditions.

A high reflection mirror comprising a substrate and a silver film formed thereon, characterized in that a protective film is formed on the topmost surface of the high reflection mirror, and the protective film has an extinction coefficient of at most 0.1, and the protective film is a carbon film. It is preferred that an underlayer is formed on the substrate side of the silver film, and it is preferred that the underlayer is a titanium oxide film, and the titanium oxide film is formed from an oxygen-deficient target.

## Description

### TECHNICAL FIELD

The present invention relates to a high reflection mirror to be used particularly suitably for a backlight module for a small size liquid crystal display of a cell-phone, etc., and a process for its production.

### BACKGROUND ART

Heretofore, a mirror utilizing a metal film for reflection has been widely used as a reflection mirror to be used for electronic equipments such as flat panel displays. For the purpose of energy saving and improvement of brightness of electronic equipments, it is important to increase the reflectance of a reflection mirror. For example, in a liquid crystal display to be used for e.g. cell-phones, a mirror to reflect backlight is used. For such a mirror, a plastic film is used as the substrate in order to reduce the weight. Further, for a liquid crystal display, a reflection mirror having a high reflectance is desired.

As the material for the metal film of a reflection mirror, aluminum has been used. However, if aluminum is used as the material for a metal film, the reflectance changes depending upon the incident angle of light, thus leading to such a problem that the reflection color varies. Further, in order to increase the reflectance, it is known to be effective to laminate a low refractive index film and a high refractive index film to have a multilayer structure, and with such a multilayer structure, it is expected to improve the scratch resistance, etc., but there is a problem such that the film-forming process tends to be complex.

In order to solve the above problems, it has been in practice to use, as a material for the metal film, silver having a higher reflectance in the visible light region than aluminum. However, silver has a problem that the adhesion with the plastic film substrate is poor, whereby the moisture resistance or durability such as salt water resistance tends to be low, although the reflectance in the visible light region is high as compared with aluminum.

As a mirror which employs an Ag film as a metal film and which has a high reflectance and is excellent in durability, a high reflection mirror is disclosed in which an Al₂O₃ film, an Ag film, an Al₂O₃ film and a TiO₂ film are laminated in this order on a glass substrate (e.g. Patent Document 1). However, this high reflection mirror has a problem such that oxygen is introduced when the Al₂O₃ film is formed on the side of the Ag film opposite to the substrate, whereby silver is likely to be oxidized, and thus the reflectance tends to be low.

Further, a reflection film is also disclosed wherein a metal such as Ce or Nd is mixed to Ag in order to improve the adhesion between the Ag film and a substrate (e.g. Patent Document 2). However, this reflection film is a single film of silver, and the disclosure is limited to the adhesion between the Ag film and a substrate, and no evaluation is made with respect to the adhesion of the Ag film with other layers.

Further, a reflection mirror is disclosed wherein an Al₂O₃ film, a ZrO₂ film and a SiO₂ film are formed on an Ag film (e.g. Patent Document 3). Here, the Al₂O₃ film is a protective film to increase the durability of the Ag film, and the ZrO₂ film is a film to improve the reflection efficiency. Further, the SiO₂ film is disclosed to be a protective film. Further, it is disclosed to form a film made of chromium oxide between a substrate and an Ag film in order to improve the adhesion between the substrate and the Ag film (e.g. Patent Document 4). Further, in order to form an Al₂O₃ film on an Ag film and further to improve the durability, it is disclosed to provide a layer of zirconium oxide, silicon dioxide, titanium oxide, hafnium oxide, tin oxide, antimony oxide or tungsten oxide (e.g. Patent Document 5). Further, in order to improve the durability, it is disclosed to provide an underlayer made of silicon oxide between the substrate and the Ag film (Patent Document 6). However, such a reflection film is problematic in that the reflectance in a visible light region is low.

Further, a reflection mirror is disclosed wherein chromium, nickel or titanium alloy is formed into a film as a metal between an Ag film and a substrate in order to improve the adhesion with the substrate (e.g. Patent Document 7). However, this reflection mirror has a laminate structure composed solely of the underlayer and the Ag film, and a protective film is evaluated for adhesion after a plastic film of e.g. polyvinyl chloride is laminated, and no evaluation is made with respect to a structure where an oxide film is formed as a protective film.

Further, recently, cell-phones, etc. are used for many purposes and applications, and liquid crystal displays are required to have sufficient durability even in a case where they are used in environments severer than ever. For example, in order to improve the hydrogen sulfide resistance of a reflection mirror, a reflection film made of silver is disclosed wherein an Ag film is sandwiched between aluminum oxide film (e.g. Patent Document 8). However, in this Patent Document 8, as a method for preparing aluminum oxide films, it is disclosed in Examples to use granules of aluminum oxide. However, this method has a problem that when aluminum oxide is deposited on the silver film, silver is likely to be oxidized, and it is difficult to obtain a high reflectance.
Patent Document 1: JP-A-2003-4919
Patent Document 2: JP-A-2002-226927
Patent Document 3: JP-A-2002-200700
Patent Document 4: JP-A-2002-55213
Patent Document 5: JP-A-2-109003
Patent Document 6: JP-A-2001-343510
Patent Document 7: JP-A-2003-297122
Patent Document 8: JP-A-2003-329818

### DISCLOSURE OF THE INVENTION

### OBJECT TO BE ACCOMPLISHED BY THE INVENTION

It is an object of the present invention to provide a high reflection mirror which has a high reflectance in a visible light region and which has moisture resistance, particularly such that it can maintain the high reflectance even after being exposed to high temperature and high humidity conditions, and also has a high hydrogen sulfide resistance, and to provide a process for its production.

### MEANS TO ACCOMPLISH THE OBJECT

The present invention provides a high reflection mirror comprising a substrate and a silver film formed thereon, characterized in that a film composed mainly of carbon is formed as a protective film on the topmost surface of the high reflection mirror, and the film composed mainly of carbon (hereinafter referred to as the carbon film) has an extinction coefficient of at most 0.1.

Further, the present invention provides such a high reflection mirror wherein an underlayer is formed on the substrate side of the silver film; such a high reflection mirror wherein the underlayer is an oxide film which is formed by a sputtering method wherein the sputtering gas contains substantially no oxidative gas; such a high reflection mirror wherein the underlayer is a titanium oxide film which is formed from an oxygen-deficient target; and such a high reflection mirror wherein the carbon film is formed by a sputtering method wherein the sputtering gas contains substantially no oxidative gas.

The present invention further provides a process for producing a high reflection mirror, characterized by forming, on a substrate, an underlayer by a sputtering method under such a condition that the sputtering gas contains substantially no oxidative gas, forming a silver film on the underlayer by a sputtering method, and forming a film composed mainly of carbon as a protective film on the topmost surface by a sputtering method under such a condition that the sputtering gas contains substantially no oxidative gas.

### EFFECTS OF THE INVENTION

The high reflection mirror of the present invention employs silver as the material of the metal film, whereby it is possible to improve the reflectance in a visible light region. Further, it has moisture resistance, particularly such that it is capable of maintaining the high reflectance even after being exposed to high temperature and high humidity conditions, and also has a high hydrogen sulfide resistance, whereby it is useful as an optical component for a display, particularly as a backlight module for a small size liquid crystal display of e.g. a cell-phone to be used in a severe environment. Further, it contributes to an improvement in brightness of the display or to simplification in the optical designing.

### BEST MODE FOR CARRYING OUT THE INVENTION

In the high reflection mirror of the present invention, the type of the substrate is not particularly limited, and it may, for example, be glass or a plastic film of a PET (polyethylene terephthalate) resin, an acrylic resin or a polycarbonate. When the substrate is a plastic film, the thickness of the plastic film substrate is preferably from 30 to 500 µm, whereby the weight reduction can be accomplished. The shape of the substrate is not particularly limited so long as it is a shape required as a substrate for various optical components for reflection, such as a flat surface, a diffusing surface, a concave surface, a convex surface or a trapezoid. Further, when the substrate is a plastic film, it is preferred that the adhesion with the substrate can be improved by applying e.g. plasma treatment to the plastic film substrate. A silver film capable of effectively reflecting light is a film composed mainly of silver, and it is preferred that it contains at least 90 atomic% of silver from the viewpoint of the reflectance in a visible light region. By using a silver film, it is possible to improve the reflectance in a visible light region and to reduce the dependency of the reflectance on the incident angle. The silver film may contain impurities such as copper, but the content of such impurities is preferably at most 10 atomic%. Further, in the present invention, "a visible light region" means a wavelength region of from 400 to 700 nm.

Further, the silver film may be an alloy film of silver with other metals. Other metals may specifically be at least one member selected from the group consisting of gold, palladium, tin, barium, indium, copper, titanium and bismuth. By making the silver film to be an alloy film with gold, the durability of the silver film will be improved, and the reflectance will be improved, such being desirable. The total content of other metals in the alloy film is preferably from 0.2 to 10 atomic% in the film, from the viewpoint of the improvement in durability. Further, the content of silver in the alloy film is preferably at least 90 atomic%, from the viewpoint of the reflectance in the visible light region.

The physical film thickness of the silver film is preferably from 60 to 300 nm, particularly preferably from 80 to 200 nm. If it is less than 60 nm, the reflectance in a visible light region tends to be low, and if it exceeds 300 nm, due to the surface irregularities, light absorption and scattering will result, and consequently, the reflectance in a visible light region tends to deteriorate, such being undesirable.

In the high reflection mirror of the present invention, it is preferred to form an underlayer on the substrate side of the silver film. By forming such an underlayer, the adhesion between the silver film and the substrate can be improved, and it becomes possible to obtain a high reflection mirror excellent in moisture resistance. From the viewpoint of the adhesion between the substrate and silver, the underlayer is preferably an oxide film. Further, it is preferred that the underlayer is formed by a sputtering method, and the sputtering gas contains substantially no oxidative gas (such as oxygen), whereby when the substrate is a plastic film, no influence will be given to the plastic film substrate. Specifically, such an underlayer is preferably at least one member selected from the group consisting of titanium oxide, zinc oxide, tin oxide, indium oxide, aluminum oxide, chromium oxide and niobium oxide. Further, the underlayer may be made of a single layer or a plurality of layers.

The physical film thickness of the underlayer is preferably from 1 to 50 nm, particularly preferably from 3 to 15 nm. If it is less than 1 nm, the effect to improve the adhesion tends to be hardly obtainable, and if it exceeds 50 nm, the surface irregularities tend to be large, whereby the reflectance tends to deteriorate, or the internal stress tends to be high, whereby the adhesion tends to deteriorate, such being undesirable. Further, the physical film thickness is different from the optical film thickness, and the physical film thickness is obtained by dividing the optical film thickness by the refractive index.

The underlayer is formed by a sputtering method, and the sputtering gas in the sputtering method preferably contains substantially no oxidative gas. The condition that the sputtering gas contains substantially no oxidative gas means that when the substrate is a plastic film, the sputtering gas does not contain an oxidative gas to present an influence over e.g. the adhesion of the plastic film substrate. Specifically, the oxidative gas in the sputtering gas is preferably at most 18 vol%. The sputtering gas is preferably a rare gas such as argon. Specifically, the oxidative gas may, for example, be oxygen or carbon dioxide. The target to be used for forming the underlayer is preferably an oxide target such as titanium oxide or an oxygen-deficient target such as a TiOₓ (1.5≦x<2.0) target, since it is thereby possible to form an oxide film even if the sputtering gas contains substantially no oxidative gas. Here, it is preferred to use an oxygen-deficient target, since it is thereby possible to form a film at a high rate by a direct current (DC) sputtering method.

The high reflection mirror of the present invention is characterized in that a protective film is formed on the topmost surface of the high reflection mirror. The silver film is by itself is susceptible to the influence of oxygen and is poor in e.g. moisture resistance. As such a protective film, an oxide film such as niobium oxide or zinc oxide is conceivable from the viewpoint of transparency. However, in a case where an oxide film is formed on the silver film by a sputtering method, it is necessary to use an oxidative gas such as oxygen as the sputtering gas. By such a method, the silver film is readily susceptible to the influence of oxygen, whereby the desired reflectance tends to be hardly obtainable. Further, a method is conceivable to form an oxide film by a sputtering method by using an oxide target under a condition not to use an oxidative gas as the sputtering gas. However, even by this method, it will be necessary to introduce a small amount of oxygen in order to maintain the transparency.

Whereas, the carbon film is made of a material composed mainly of carbon (graphite), whereby it is not necessary to introduce oxygen into the sputtering gas, and it is possible to suppress the influence of oxygen over the silver film, whereby the improvement of the reflectance can be expected. Further, the carbon film exhibits good adhesion to the silver film as an under layer, and thus requires no under-coating layer, and thus is excellent also in the economical efficiency.

Further, by using the carbon film, the high reflectance can be maintained even under high temperature and high humidity conditions, and it is preferred that the reflectance will not decrease even after the high reflection mirror is exposed to hydrogen sulfide. The reason of the excellent hydrogen sulfide resistance of this carbon film may be as follows. As a process where the reflectance decreases by erosion of a silver film with hydrogen sulfide, a process is assumed wherein firstly hydrogen sulfide will deposit on the protective film, and then penetrates and permeates in the film. Accordingly, firstly, it is considered that if deposition of hydrogen sulfide on the protective film is suppressed, the hydrogen sulfide resistance can be improved. In a case where a carbon film is adopted as the protective film, the energy for binding the carbon atom in the carbon film and the sulfur atom in hydrogen sulfide is high, and a large energy will be required for deposition on the film surface, and consequently, the amount of sulfur to be deposited on the film surface will be small, whereby the hydrogen sulfide resistance will be excellent.

By the formation of the carbon film, it is possible to prevent oxidation of the silver film and to improve the moisture resistance and hydrogen sulfide resistance of the high reflection mirror. Further, in a case where the carbon film is formed by a sputtering method, it is not required to add an oxidative gas such as oxygen to the sputtering gas, which is excellent in that oxidation of the silver film may be prevented, and deterioration of the reflectance may be prevented. The carbon film is required to be a transparent film from the viewpoint of the reflectance. Specifically, its extinction coefficient is at most 0.1, preferably at most 0.08, particularly preferably at most 0.05. In the present invention, the extinction coefficient means an extinction coefficient in a visible light region with a wavelength of from 400 to 700 nm.

The physical film thickness of the carbon film is preferably from 2 to 20 nm, particularly preferably from 4 to 10 nm. If it is less than 2 nm, the effect to improve the adhesion tends to be hardly observed, and if it exceeds 20 nm, the reflectance tends to be low, such being undesirable. By using the carbon film as a protective film, the hydrogen sulfide resistance will be excellent even with such a thin film thickness, such being desirable. Further, the refractive index means a real part of a complex refractive index and the extinction coefficient means an imaginary part in a complex refractive index in a visible light region, and they may, respectively, measured by a spectroscopic ellipsometer (e.g. VASE, manufactured by J.A. Woollam).

The content of carbon in the carbon film is preferably at least 50 mass%, particularly preferably at least 80 mass%, further preferably at least 90 mass%, based on all elements in the carbon film. The carbon film may contain other elements. Such other elements may specifically be, for example, hydrogen and/or fluorine.

The hardness of the carbon film increases by addition of hydrogen in the film. Accordingly, by forming a carbon film in a hydrogen-incorporated argon atmosphere, the abrasion resistance or weatherability of the high reflection mirror can readily be improved. The total content of carbon and hydrogen in the carbon film is preferably at least 95 atomic%. However, in a case where the substrate is a plastic film, the carbon film is required to be soft to such an extent that it conforms with the plastic film. Accordingly, when hydrogen is added, it is preferred to adjust its content. The reason for the improvement of the weatherability by the addition of hydrogen is not clearly understood, but is conceivable that many unattached defects in the carbon film will be stabilized by the addition of hydrogen.

It is preferred that the carbon film is formed by a sputtering method, and the sputtering gas will be used in the sputtering method containing substantially no oxidative gas. The condition that the sputtering gas contains substantially no oxidative gas means that when the substrate is a plastic film, an oxidative gas influential over the plastic film substrate in e.g. the adhesion is not contained in the sputtering gas. Specifically, it is preferred that the oxidative gas in the sputtering gas is at most 1 vol%. The sputtering gas is preferably a rare gas such as argon. The oxidative gas may, specifically, be, e.g. oxygen or carbon dioxide.

With the carbon film, there may be a case where the properties of the film tend to be substantially different depending upon the film deposition method. The properties of the film may be classified mainly by the energy of carbon particles reaching the substrate. When the carbon film is formed by the sputtering method, the bonding of carbon atoms to one another tends to be SP² bond. Accordingly, it is difficult to form a diamondlike carbon film having many SP³ bonds which is a very strong film. However, in the present invention, many of bonds of carbon atoms are made to be SP² bonds, whereby the film can be made to be amorphous, and thus it is considered possible to form a film having high hydrogen sulfide resistance.

As described above, the high reflection mirror of the present invention has multiple layers including the silver film and the carbon film, on one side of the substrate. However, such multiple layers may be formed on both sides of the substrate. Further, such multiple layer structures on both sides may be the same or different.

The high reflection mirror of the present invention preferably has a film surface reflectance of at least 90%, particularly preferably at least 95%, more preferably at least 97%. In the high reflection mirror of the present invention, the film surface reflectance will have such a high value, and in an electronic equipment such as a projection TV or a liquid crystal display, even if reflection is repeated, it will be possible to project an image without deterioration of the brightness. Further, an incident angle means an angle to a line vertical to the film surface. Further, for the film surface reflectance (the reflectance to the incident light from the film surface side), the luminous reflectance as defined in JIS Z8701 (1982) will be used.

The high reflection mirror of the present invention can be formed by a sputtering method by means of an oxide target, a metal target and a graphite target. Now, the process for producing the high reflection mirror will be described in a case where the high reflection mirror comprises an underlayer, a silver film and a protective film sequentially from the substrate. Firstly on the plastic film substrate, (1) an underlayer is formed by a sputtering method by means of an oxide target, (2) on this underlayer, a silver film is formed by a sputtering method by means of a target of silver or a silver alloy and (3) on this silver film, a protective film is formed by a sputtering method by means of a graphite target. As compared with a CVD method or an ion plating method, the sputtering method is excellent in that a film having a large area can be formed, and a transparent film can easily be formed. Further, the surface roughness can be made small, and it is excellent in that the reflectance can be maintained at a high level.

As the sputtering method, an alternate current (AC), direct current (DC) or radio frequency (RF) sputtering method may be employed. The DC sputtering method includes a pulse DC sputtering method. The AC sputtering method and the pulse DC sputtering method are effective with a view to preventing abnormal electrical discharge. Further, from a viewpoint that a dense film can be formed, the AC or DC reactive sputtering method is effective.

### EXAMPLES

Now, the high reflection mirror of the present invention will be described in detail with reference to Example (Example 1) and Comparative Examples (Example 2 and 3). However, it should be understood that the present invention is by no means restricted by the following Examples.

### EXAMPLE 1

In a vacuum chamber, a flat PET film having an acrylic hard coat applied (thickness: 50 µm) was set as a substrate. As targets, a TiOₓ oxygen-deficient target (tradename: TXO, manufactured by Asahi Glass Ceramics Co., Ltd.), an Au-doped silver alloy target (Au content: 1 atomic%, silver content: 99 mass%) and a graphite target (IG-15, manufactured by Toyo Tanso Co., Ltd., carbon content: at least 99.6 mass%) were, respectively, set at positions opposing to the plastic film substrate above the cathode. The interior of the vacuum chamber was evacuated to 2×10⁻⁵ Pa. Then, the following treatments (A) to (D) were carried out to obtain a high reflection mirror.

### (A) PRETREATMENT STEP FOR PLASTIC FILM SUBSTRATE

200 sccm of argon gas was introduced to the vacuum chamber, and the substrate was irradiated with ionized Ar ions from an ion beam source (LIS-150, manufactured by Advanced Energy) by applying an electric power of 100 W to carry out dry cleaning of the substrate.

### (B) FORMATION OF UNDERLAYER (TITANIUM OXIDE FILM)

As a sputtering gas, argon gas was introduced to the vacuum chamber. By a DC sputtering method, pulse sputtering with a reverse pulse width of 1 µsec was carried out under a pressure of 0.15 Pa at a frequency of 100 KHz at a power density of 0.79 w/cm² by means of a TiOₓ target to form a titanium oxide film in a thickness of 5 nm on a substrate. The composition of the titanium oxide film was equal to the target.

### (C) FORMATION OF SILVER ALLOY FILM

The remaining gas was discharged, and then, as a sputtering gas, argon gas was introduced into the vacuum chamber. By a DC sputtering method, pulse sputtering with a reverse pulse width of 5 µsec was carried out under a pressure of 0.15 Pa, at a frequency of 100 KHz at a power density of 2.46 w/cm² by means of an Au-doped silver alloy target to form an Au-doped silver alloy film in a thickness of 150 nm on the underlayer. The composition of the silver alloy film was equal to the target.

### (D) FORMATION OF PROTECTIVE FILM (HYDROGENATED CARBON FILM)

A graphite target was used, and as a sputtering gas, hydrogen and argon gas were respectively introduced into a vacuum chamber and adjusted so that hydrogen would be 50% in the sputtering gas. Oxygen was not intentionally introduced. Pulse sputtering with a reverse pulse width of 4.5 µsec was carried out under a pressure of 0.25 Pa at a frequency of 100 KHz at a power density of 2.46 w/cm² to form a hydrogenated carbon film in a thickness of 5 nm.

The durability of the high reflection mirror formed was evaluated by the following methods (1) to (7), and the results are shown in Tables 1 to 4.

### (1) HIGH TEMPERATURE HIGH HUMIDITY TEST

The formed high reflection mirror was cut into 50 mm × 100 mm to obtain a sample. The sample was left to stand for 100 hours in an atmosphere at a temperature of 60°C with a relative humidity of 90%, whereupon the delamination and the presence or absence of corrosion were ascertained. ○: No stripping of the film or corrosion was observed. ×: Stripping of the film or corrosion was observed.

### (2) HIGH TEMPERATURE TEST

The formed high reflective multilayer film was cut into 50 mm × 100 mm to obtain a sample. The sample was left to stand for 100 hours in an atmosphere at a temperature of 85°C under a relative humidity of at most 30%, whereupon delamination and the presence or absence of corrosion were ascertained. ○: No stripping of the film or corrosion was observed. ×: Stripping of the film or corrosion was observed.

### (3) TAPE-PEELING TEST

The film surface of the formed high reflection mirror was cut by a cutter to form 100 cross-cut sections. An adhesive tape (manufactured by Nichiban Co., Ltd.) was strongly bonded to the film surface manually and rapidly peeled, whereupon the presence or absence of peeling of the cross-cut sections of the film surface was ascertained. A case where no peeling was observed was rated to be 100/100, and a case where all sections were peeled was rated to be 0/100. Such a peeling test was carried out after the film deposition, after the high temperature high humidity test and after the high temperature test.

### (4) FILM SURFACE REFLECTANCE

By means of a color analyzer (TOPSCAN, manufactured by Tokyo Denshoku Co., Ltd.), the reflectance of the film surface side was measured, and chromaticity Y of the tristimulus value as defined in JIS Z8701 (1982) was obtained by calculation, and the luminous reflectance was taken as the film surface reflectance. The measurement was carried out by a SCI system wherein both the regular reflected light and the diffusion light were measured. The luminous reflectance was measured after the film deposition, after the high temperature high humidity test and after the high temperature test.

### (5) HYDROGEN SULFIDE RESISTANT TEST

The formed high reflectance mirror was cut into 50 × 100 mm to obtain a sample. 10 ppm of hydrogen sulfide was introduced, and the sample was left to stand for 100 hours in an atmosphere at a temperature of 50°C under a relative humidity of 80%, whereupon the luminous reflectance, and the delamination and the presence or absence of corrosion were ascertained. Here, the luminous reflectance was measured by the same method as in (4). With respect to the presence or absence of corrosion, ○: No stripping of the film or corrosion was observed. Δ: Stripping of the film or corrosion was slightly observed, but was not a practically problematic level. ×: Stripping of the film and corrosion were observed.

### (6) MEASUREMENT OF THE DEPOSITED AMOUNT OF SULFUR

By means of XPS (Quantum 2000, manufactured by ULVAC-PHI, INCORPORATED), the amount of sulfur deposited on the sample surface after the above hydrogen sulfide resistance test, was measured. As the X-ray source, monochromatic AlKa rays were used, and the analysis was carried out by setting the detector at an angle of 45° to the sample surface. The 2P orbit of sulfur was detected, and the peak intensity was observed, whereby the amount of sulfur present on the surface was assumed. The higher the peak intensity, the larger the deposited amount, and zero means there is no deposition of sulfur.

### (7) MEASUREMENT OF EXTINCTION COEFFICIENT

By means of a spectroscopic ellipsometer (model: VASE, manufactured by J.A. Woollam), the obtained sample was measured at a measuring angle of 60°, 70° or 80° within a wavelength range of from 400 to 700 nm, and then, using data of spectroscopic reflectance measured at an incident angle of 5°, fitting was carried out to obtain the extinction coefficient.

### EXAMPLE 2 (COMPARATIVE EXAMPLE)

A high reflection mirror was obtained by carrying out the same treatment as in Example 1 except that the protective film was changed to a niobium oxide film instead of the hydrogenated carbon film. The formed high reflection mirror was evaluated by the same methods as in Example 1, and the results are shown in Tables 1 to 3. Here, the niobium oxide film was formed by the following method.

As a sputtering gas, argon gas was introduced into a vacuum chamber. By a DC sputtering method, pulse sputtering with a reverse pulse width of 2 µsec was carried out under a pressure of 0.15 Pa at a frequency of 100 KHz at a power density of 1.47 w/cm² by means of a NbOₓ oxygen-deficient target (tradename: NBO, manufactured by Asahi Glass Ceramics Co., Ltd.) to form a niobium oxide film in a thickness of 5 nm on the substrate. The composition of the niobium oxide film was equal to the target.

### EXAMPLE 3 (COMPARATIVE EXAMPLE)

A high reflection mirror was formed by the same treatment as in Example 1, except that no protective film was formed in Example 1. The formed high reflection multilayer film was evaluated by the same methods as in Example 1, and the results are shown in Tables 1 to 3.

**TABLE 1**

| | High temperature high humidity test | High temperature test | Tape-peeling test (after film deposition) | Tape-peeling test (after high temperature high humidity test) | Tape-peeling test (after high temper -ature test) |
|---|---|---|---|---|---|
| Ex.1 | ○ | ○ | 100/100 | 100/100 | 100/100 |
| Ex.2 | ○ | ○ | 100/100 | 100/100 | 100/100 |
| Ex.3 | ○ | ○ | 100/100 | 100/100 | 100/100 |

**TABLE 2**

| | Reflectance (%) (after film deposition) | Reflectance (%) (after high temperature high humidity test) | Reflectance (%) (after high temperature test) |
|---|---|---|---|
| Ex.1 | 98 | 98 | 98 |
| Ex.2 | 97.6 | 97.6 | 97.6 |
| Ex.3 | 99.5 | 99.5 | 89.5 |

**TABLE 3**

| | Corrosion (after hydrogen sulfide resistance test) | Reflectance (%) (after hydrogen sulfide resistance test) | Deposited amount of sulfur |
|---|---|---|---|
| Ex.1 | ○ | 97 | 0 |
| Ex.2 | × | 54.1 | 6,773 |
| Ex.3 | × | 9.3 | At least 14,332 |

**TABLE 4**

| | Extinction coefficient |
|---|---|
| Ex.1 | 0.058 |

In the high reflection mirror of Example 1, a hydrogenated carbon film was used as the material for the protective film, whereby the reflectance after the durability test such as the high temperature high humidity test is as high as at least 98%, and even after the hydrogen sulfide resistance test, the decrease in the reflectance as compared with prior to the hydrogen sulfide resistance test is at most 2%; and sulfur present on the surface is less than the detection limit and is substantially non-existent, whereby the hydrogen sulfide resistance is excellent. Further, by the formation of the underlayer obtained by a sputtering method by means of an inert gas, the adhesion after the durability test such as the high temperature high humidity test, is excellent.

Whereas, in Example 2, niobium oxide was used as the material for the protective film, whereby the reflectance after the durability test such as the high temperature high humidity test is high, but the hydrogen sulfide resistance is poor, such being undesirable. Further, in Example 3, no protective film was formed, whereby the durability in the high temperature test, etc. and the hydrogen sulfide resistance are poor, such being undesirable.

### INDUSTRIAL APPLICABILITY

The high reflection mirror of the present invention is useful as a reflection member for a light source for a display to be used for flat panel displays, projection TV, cell-phones, etc. Especially, the high reflection mirror of the present invention is excellent in durability such as moisture resistance or hydrogen sulfide resistance and thus is useful for a reflection component for a light source for a display of a portable electronic equipment such as a mobile PC, a cell-phone, PDA, a portable game equipment, etc.

Particularly, the high reflection mirror of the present invention is useful as a high reflection mirror to be used for a backlight module for a small size liquid crystal display such as a cell-phone.

The entire disclosures of Japanese Patent Application No. 2005-102839 filed on March 31, 2005 and Japanese Patent Application No. 2005-167066 filed on June 7, 2005 including specifications, claims and summaries are incorporated herein by reference in their entireties.

## Claims

1. A high reflection mirror comprising a substrate and a silver film formed thereon, **characterized in that** a film composed mainly of carbon is formed as a protective film on the topmost surface of the high reflection mirror, and the film composed mainly of carbon has an extinction coefficient of at most 0.1.

2. The high reflection mirror according to Claim 1, wherein an underlayer is formed on the substrate side of the silver film.

3. The high reflection mirror according to Claim 2, wherein the underlayer is an oxide film which is formed by a sputtering method wherein the sputtering gas contains substantially no oxidative gas.

4. The high reflection mirror according to Claim 2 or 3, wherein the underlayer is a titanium oxide film which is formed from an oxygen-deficient target.

5. The high reflection mirror according to any one of Claims 1 to 4, wherein the film composed mainly of carbon is formed by a sputtering method wherein the sputtering gas contains substantially no oxidative gas.

6. The high reflection mirror according to any one of Claims 1 to 5, wherein the underlayer has a physical film thickness of from 1 to 50 nm, the silver film has a physical film thickness of from 60 to 300 nm, and the film composed mainly of carbon has a physical film thickness of from 2 to 20 nm.

7. A process for producing a high reflection mirror, **characterized by** (1) forming, on a substrate, an underlayer by a sputtering method under such a condition that the sputtering gas contains substantially no oxidative gas, (2) forming a silver film by a sputtering method, and (3) forming a film composed mainly of carbon as a protective film on the topmost surface by a sputtering method under such a condition that the sputtering gas contains substantially no oxidative gas.
